# FASCICULE DE BREVET EUROPEEN

(11) **EP 2 053 646 B1**
(45) Date de publication et mention de la délivrance du brevet: **18.08.2010**
(21) Numéro de dépôt: 08167277.6
(22) Date de dépôt: 22.10.2008
(51) Int. Cl.: H01L 25/10, H01L 21/98, H01L 23/58, H01L 21/56, H01L 21/60

(54) **Procede d'interconnexion verticale au sein de modules electroniques 3D utilisant des vias**
Verfahren zur vertikalen Verbindung durch Vias in dreidimensionallen elektronischen Modulen
Method for vertical interconnection inside 3D electronic modules using vias

(30) Priorité: 26.10.2007 FR 0707557
(43) Date de publication de la demande: 29.04.2009
(73) Titulaire: 3D Plus, 78532 Buc Cedex (FR)
(72) Inventeur: Val, Christian, 78470 St Remy Les Chevreuse (FR)
(74) Mandataire: Henriot, Marie-Pierre

(56) Documents cités:
- WO-A-03/005782
- US-A- 6 002 592
- US-A1- 2004 115 863
- US-A1- 2006 258 044
- US-A1- 2007 018 313
- US-A1- 2007 099 345

## Description

Le domaine de l'invention est celui de la fabrication de modules électroniques 3D et plus précisément de leur interconnexion verticale.

Un module électronique 3 D comprend un empilement de tranches électroniques dont l'interconnexion s'effectue en trois dimensions en utilisant les faces latérales de l'empilement pour réaliser les connexions entre les tranches. Un tel module est par exemple connu du document WO 03/005782 A2.

Il est connu de relier électriquement les tranches entre elles par des conducteurs situés sur les faces latérales de l'empilement, c'est-à-dire sur les bords des tranches. Le nombre de conducteurs présents sur une face latérale est donc limité par la surface de celle-ci.

Par ailleurs il est souhaitable de pouvoir procéder à la fabrication collective de modules 3D de façon à en diminuer le coût.

En conséquence, il demeure à ce jour un besoin pour un procédé de fabrication de modules électroniques 3D donnant simultanément satisfaction à l'ensemble des exigences précitées, à savoir un accroissement du nombre de connexions électriques entre les tranches, une fabrication collective.

Ces conducteurs sont espacés les uns des autres d'un pas typiquement de 200 µm. Le nombre de conducteurs présents sur une face latérale est donc limité par la surface de celle-ci divisée par le pas.

Le principe de l'invention est de diviser le pas des conducteurs. Ceci est obtenue en créant des vias dans le module électronique sans se limiter aux faces latérales de celui-ci. De tels modules électroniques sont par exemple connus des documents US 2007/018 313 A1 et WO 03/005782 A2.

Plus précisément l'invention a pour objet un procédé selon la revendication 1. Ce procédé étant un procédé d'interconnexion verticale de n modules électroniques 3D, n étant un entier supérieur à 1, un module comportant un empilement de K tranches électroniques, une tranche i, i variant de 1 à K comprenant au moins un composant électronique, les K tranches étant reliées électriquement entre elles par des conducteurs situés selon la direction de l'empilement, et comprend une première étape consistant pour chaque tranche i, en :
A1) une étape de fabrication d'un lot de n tranches sur une même plaque, une plaque comportant au moins n motifs géométriques délimités par des chemins de découpe, chaque motif étant muni d'au moins un composant électronique entouré de résine isolante et connecté à des plots de connexion électrique, les plots étant reliés à des pistes de connexion électrique déposées sur une couche diélectrique qui recouvre le composant électronique et la résine mais qui ne recouvre pas complètement les plots. Il est principalement **caractérisé en ce que** chaque piste s'étend jusqu'à une électrode d'interconnexion des pistes entre elles, et située sur les chemins de découpe, et comprend un segment courbe disposé entre 2 segments droits, le segment courbe délimitant une zone qui entoure un emplacement destiné à former un via, cette zone étant disposée entre le plot de connexion et l'électrode d'interconnexion des pistes,
A2) répéter K fois l'étape A1 pour obtenir K plaques,
et en qu'il comprend une deuxième étape consistant à :
B) empiler et assembler les K plaques obtenues à l'issue de la première étape, de manière à superposer lesdites zones, sensiblement les unes sur les autres,
C) percer des vias dans la résine selon la direction de l'empilement et sur toute l'épaisseur de celui-ci à l'aplomb desdits emplacements destinés à former des vias, la section des vias étant telle que pour chaque tranche, les segments droits affleurent sur les vias mais pas les segments courbes,
D) métalliser la paroi des vias par croissance électrolytique,
E) découper l'empilement selon les chemins de découpe, la largeur de la découpe étant supérieure à celle de l'électrode d'interconnexion des pistes, en vue d'obtenir les n modules électroniques 3D.

De préférence, au moins un des segments droits présente un dépassement à l'intérieur de ladite zone.

D'autres caractéristiques et avantages de l'invention apparaîtront à la lecture de la description détaillée qui suit, faite à titre d'exemple non limitatif et en référence aux dessins annexés dans lesquels :
la figure 1 représente schématiquement l'étape de dépôt d'un film sur les faces actives d'une plaque,
la figure 2 représente schématiquement l'étape d'amincissement de la plaque,
la figure 3 représente schématiquement l'étape de dépôt d'un film adhésif,
la figure 4 représente schématiquement les puces découpées,
la figure 5 représente schématiquement l'étape de report des puces sur un film adhésif,
la figure 6 représente schématiquement l'étape d'enrobage des puces dans une résine,
la figure 7 représente schématiquement un KGRW,
la figure 8 représente schématiquement l'étape de dépôt d'une couche de diélectrique,
les figures 9 représentent schématiquement l'étape de réalisation de la couche de redistribution aussi désignée étape de routage 2D,
la figure 10 représente schématiquement l'étape de dépôt d'une couche de protection de la couche de redistribution,
la figure 11 représente schématiquement l'étape d'amincissement du KGRW,
la figure 12 représente schématiquement l'étape de retrait de la couche de protection,
la figure 13 représente schématiquement l'étape de dépôt d'un film adhésif,
la figure 14 représente schématiquement l'étape d'empilement de plusieurs KGRW,
les figures 15 représentent schématiquement l'étape de percement de vias,
les figures 16 représentent schématiquement l'étape de métallisation des vias,
les figures 17 représentent schématiquement différents exemples de formes de vias et de segments courbes des pistes,
la figure 18 représente schématiquement l'étape de dépôt d'une couche de protection des pistes de la dernière plaque,
la figure 19 représente schématiquement l'étape de découpe de l'empilement,
la figure 20 représente schématiquement un module 3D.

D'une figure à l'autre, les mêmes éléments sont repérés par les mêmes références.

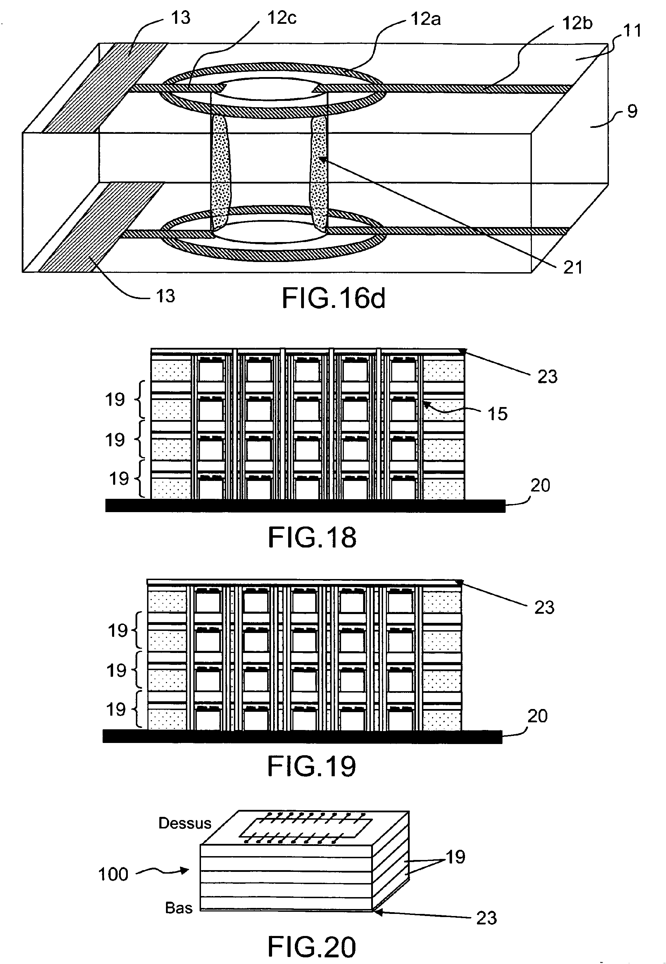

Un module électronique 3D 100 dont un exemple est représenté figure 20, comporte un empilement de K tranches électroniques 19 ; une tranche i, i variant de 1 à K comprend sur un substrat isolant au moins un composant électronique. Les K tranches sont reliées électriquement entre elles par des conducteurs situés dans l'empilement. K est par exemple égal à 4 mais varie typiquement entre 2 et 100.

L'invention concerne la fabrication de n modules ( n compris entre 2 et 500), cette fabrication étant collective.

Elle comprend une étape de fabrication d'un lot de n tranches sur une même plaque, cette étape étant répétée K fois, puis une étape d'empilement des K plaques, de formation de vias métallisés dans l'épaisseur de l'empilement et destinés à la connexion des tranches entre elles, puis de découpe de l'empilement pour obtenir les n modules 3D.

On va à présent décrire un exemple de mode de réalisation de modules 3D.

Une première phase du procédé consiste à obtenir des plaques (« wafers » en anglais) ne comportant pas de composants (ou puces) défectueux, aussi désignées plaques reconstituées ou « Known Good Rebuilt Wafer » (KGRW). Cette phase comprend des étapes de prélèvement, de retournement et de positionnement des puces sélectionnées, sur une plaque. Le composant électronique peut être un composant actif tel qu'une puce nue ou un composant passif ou un MEMS (acronyme de l'expression anglo-saxonne Micro Electro Mechanical System) ; le composant passif peut être situé dans la plaque ou sur la plaque.

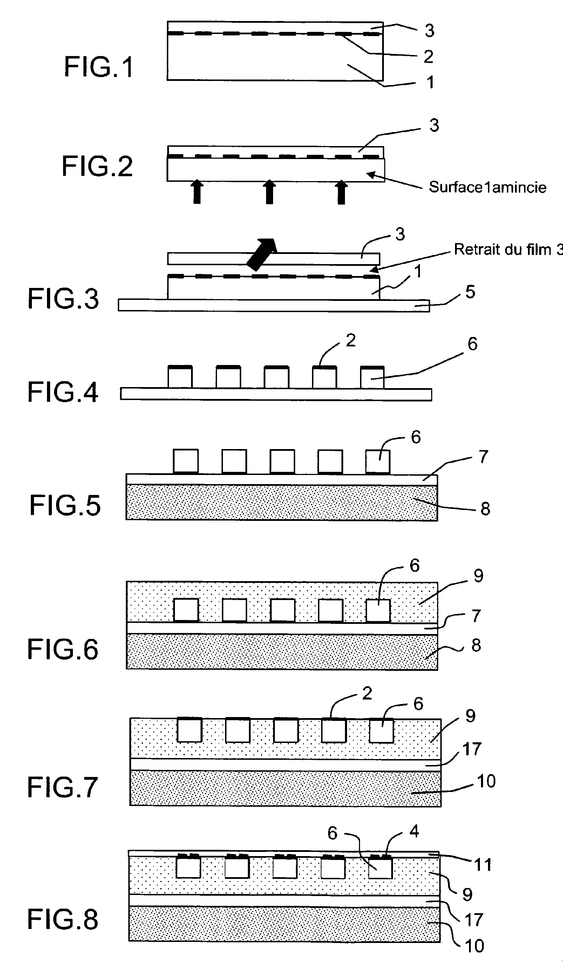

La figure 1 montre un film 3 UV (ultra-violet) de rodage déposé sur les faces actives 2 de puces 6 formées dans une plaque 1 par exemple une plaque de silicium. Sa fonction consiste non seulement en la protection des faces actives 2, mais aussi à rigidifier la plaque 1 lors de son amincissement et de sa manipulation.
La figure 2 montre la plaque 1 de silicium juste après son amincissement. Celui-ci est réalisé en deux étapes. Un rodage mécanique permet dans un premier temps, d'amincir la plaque du côté opposé aux faces actives 2, puis une gravure chimique sur la surface amincie est réalisée, dans un second temps, dans l'intention de relaxer les contraintes générées lors du rodage.
La figure 3 montre la plaque 1 collée sur un film UV de sciage 5 et le retrait du film de rodage 3 par insolation.
La figure 4 montre les puces 6 de silicium découpées. Le sciage est de préférence sans éclat afin de favoriser les étapes suivantes à savoir le prélèvement, le retournement et un positionnement optimisé.
La figure 5 montre des puces 6 montées retournées sur un film double adhésif 7. Les puces 6 ont préalablement été testées collectivement avant leur découpe et seulement des puces sélectionnées (« Known Good Die ») sont montées sur le film 7 qui a des motifs de positionnement. Il s'agit là d'une des étapes les plus critiques du procédé. En effet, les puces sont prélevées, retournées et placées sur le film avec une haute précision afin de respecter les tolérances d'alignement requises. Le film 7 est collé sur un support 8. On obtient alors un KGRW.
La figure 6 montre un KGRW réalisé par la technologie de moulage par compression. Cette technologie garantit un moulage dépourvu de déplacement de matière de sorte que la précision du positionnement des puces est conservée après le moulage par exemple dans une résine polymère 9.

Depuis cette étape et ce jusqu'à la fin du procédé, un choix optimisé des matériaux est fondamental. Les matériaux doivent être à la fois thermo-mécaniquement compatibles entre eux et thermiquement compatibles avec les différentes étapes du procédé. Les coefficients de dilatation thermique de l'ensemble des matériaux doivent être aussi proches que possible les uns des autres, pour éviter les désaccords thermomécaniques et les conséquences engendrées (déformations, délaminations, craquelures, ...), et ce, pour toutes les températures associées au déroulement du procédé.

La plaque 8 de silicium et l'adhésif 7 sont retirés.

La figure 7 montre le KGRW remonté sur un autre support 10 par exemple un support de silicium de façon à ce que les faces actives 2 des puces 6 soient orientées sur la partie supérieure. Le KGRW est collé sur la plaque 10 au moyen d'un adhésif 17.

La figure 8 montre le dépôt d'un diélectrique 11 photo-imageable sur le KGRW constituant la première étape de réalisation d'une couche de redistribution ou « RDL ». Ce diélectrique 11 a pour fonction en premier lieu d'éviter tout court-circuit entre la puce et la future piste métallique, et d'être employée comme couche tampon thermo mécanique en second lieu. Des motifs géométriques (n) délimités par des chemins de découpe 14 sont formés sur la plaque ; chaque motif comprend au moins un composant électronique 6 (ou puce) par exemple en silicium, entouré de résine isolante 9 et connecté à des plots de connexion électrique 4.

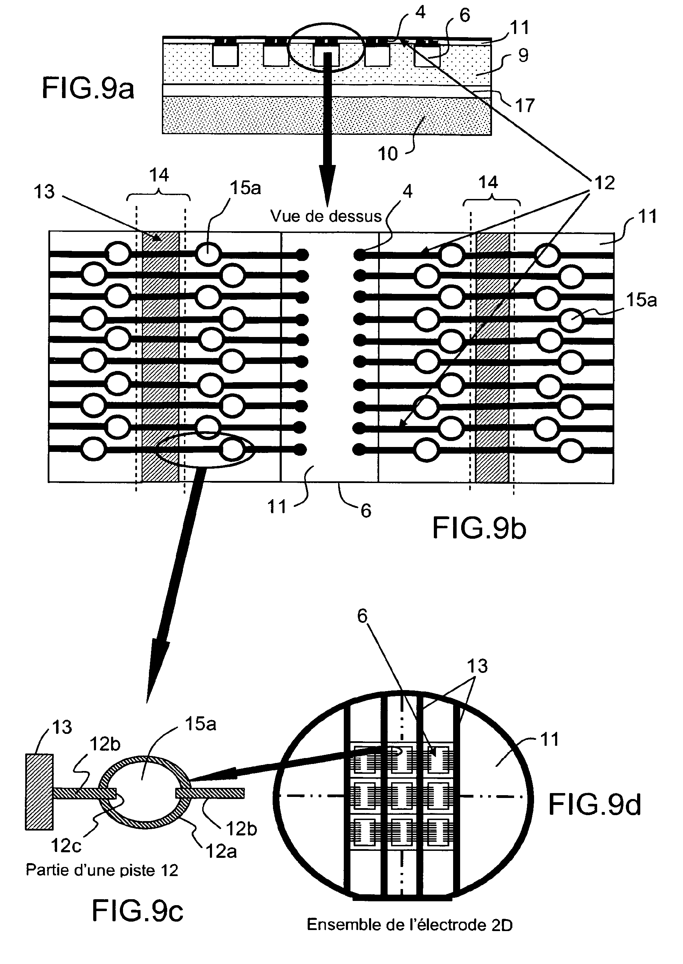

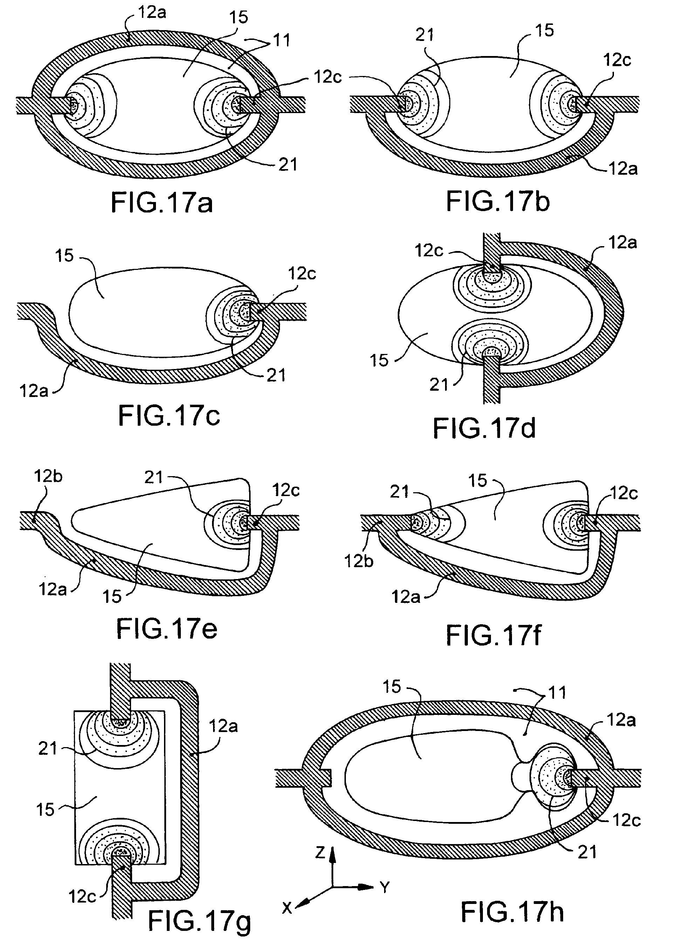

Les figures 9 montrent la RDL achevée, c'est-à-dire complétée par des pistes métalliques 12 réalisées au moyen d'une technologie connue de l'homme du métier : par exemple métallisation + masquage + gravure ou seed layer + masquage + cuivrage sélectif + gravure seed layer. Le routage 2D visible figures 9b et 9d est conçu de sorte que les pistes 12 soient connectées d'une part aux plots de connexion 4 de la puce et d'autre part à une électrode 13 interconnectant les pistes entre elles ; il s'agit par exemple d'une électrode de cuivre. Cette électrode 13 est située sur les chemins de découpe 14. Comme on le verra plus loin cette électrode 13 sera utilisée lors de l'étape de métallisation des vias d'interconnexion verticale. Chaque piste 12 est formée d'un segment courbe 12a situé entre 2 segments droits 12b visibles figure 9c ; ce segment courbe 12a délimite dans l'isolant 11 une zone 15a qui entoure l'emplacement d'un futur via vertical, ce segment courbe étant disposé entre la puce 6 et l'extrémité de la piste qui rejoint l'électrode 13 comme le montrent les figures 9b et 9c. Les zones 15a sont placées le long de 1 à n rangées, les rangées étant de préférence décalées les unes par rapport aux autres comme on le voit sur la vue de dessus figure 9b de manière à augmenter le nombre de vias ; sur la figure il y a deux rangées de chaque côté de la puce 6. Le segment de piste courbe 12a peut avoir une forme totalement ou partiellement circulaire (il est totalement circulaire sur la figure) ou oblongue ou triangulaire ou rectangulaire ou autre comme illustré figures 17. De préférence, au niveau de la jonction entre le segment droit 12b et le segment courbe 12a de la piste, le segment droit dépasse légèrement à l'intérieur de la zone 15a et forme un dépassement 12c. Les deux segments 12b peuvent dépasser comme il apparaît sur les figures 9c, 16b, 17a, 17b, 17d, 17f, 17g ou seulement l'un d'entre eux comme il apparaît sur les figures 17c, 17e.

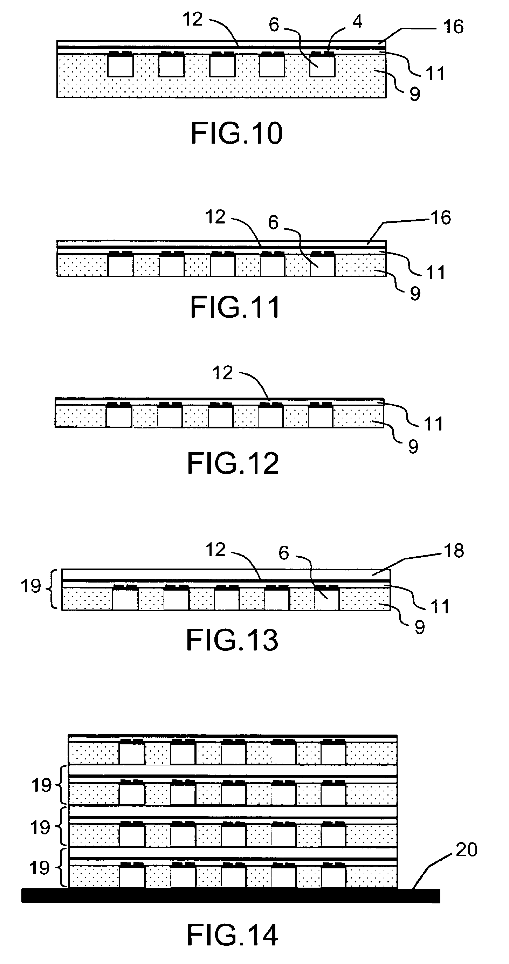

La figure 10 montre un film de protection 16 déposé sur la face supérieure du KGRW permettant de réaliser l'amincissement final ; la plaque 10 de silicium et l'adhésif 17 ont été retirés. La solution présentée sur la figure 11 consiste à amincir le KGRW après avoir réalisé la RDL ; selon une variante, on peut également mouler directement le KGRW sur une épaisseur désirée, puis réaliser la RDL par la suite sans amincissement.

La figure 11 montre le KGRW complètement aminci. Le rodage permet d'amincir l'ensemble des puces 6 quelle que soit leur épaisseur initiale en fonction du standard d'épaisseur des plaques. Sur la figure 11, le KGRW est aminci jusqu'à la puce 6 pour atteindre la plus faible épaisseur du KGRW. Une alternative consisterait à conserver une épaisseur de résine 9 en arrêtant l'amincissement avant d'atteindre les puces 6 de silicium. Cette épaisseur additionnelle ou surmoulage peut assurer une meilleure résistance des puces aux problèmes de cambrures et de contraintes générées lors des sollicitations thermiques.

La figure 12 montre le KGRW après le retrait du film de protection 16.

La figure 13 montre une colle 18 déposée sur le KGRW. Cette colle peut être soit un film adhésif double face ou une colle adhésive liquide de type Epoxie. Cette dernière est préférée lorsque le KGRW est aminci jusqu'à la puce. En effet, la colle permet la réalisation d'un enrobage avec une matière très proche de la résine employée lors du moulage par compression.

A l'issue de cette première phase on a obtenu une plaque KGRW 19 destinée à être empilée. Cette phase est reproduite K fois ; K est par exemple égal à 4 mais varie typiquement entre 2 et 100.

La deuxième phase concerne l'empilement des KGRWs 19.

La figure 14 montre un empilement des KGRW les uns sur les autres. Des mires de positionnement spécifiques, moulées dans le KGRW, servent à empiler avec précision les KGRW de manière à ce que les emplacements délimitant les futurs vias soient alignés les uns sur les autres. Un film de montage 20 est employé en guise de support, pour l'empilement des modules 3D. L'adhésif 18 de la plaque 19 supérieure est retiré.

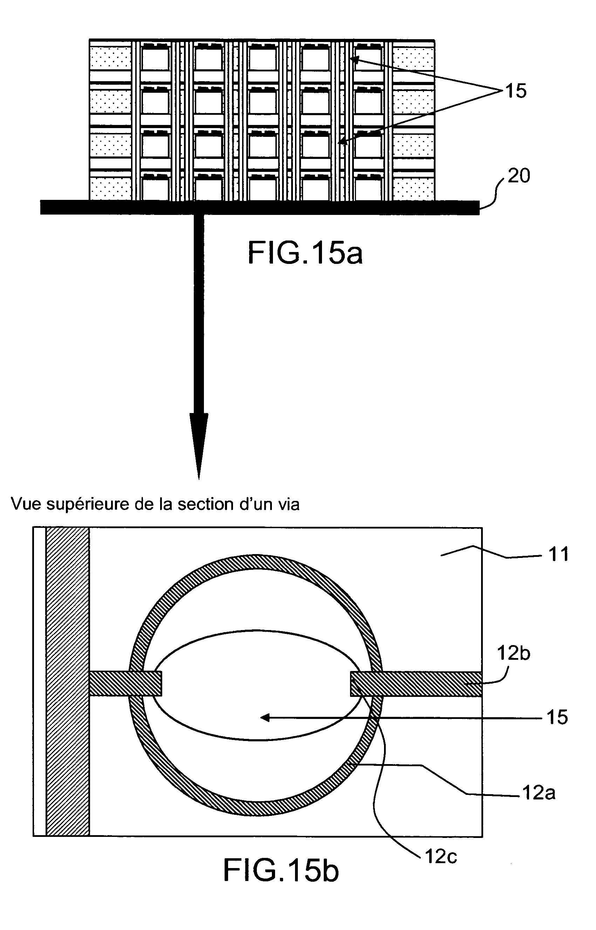

Les figures 15 montrent les vias 15 perforés dans un empilement. Plusieurs techniques de perforation peuvent être retenues (gravure sèche par laser ou plasma, gravure liquide, ...) notamment en fonction de l'épaisseur à perforer ; cette étape est réalisée directement sur l'empilement.

La gravure sèche par plasma utilise un plasma actif comportant plusieurs gaz ; l'un par exemple O₂ pour attaquer la résine, un autre par exemple CF₄ pour attaquer la silice de la résine, un troisième par exemple de l'argon pour décaper le cuivre des segments de piste qui affleurent. Les vias 15 sont perforés de manière à faire apparaître les sections sans dépassements des segments droits 12b des pistes ou à laisser apparaître les dépassements 12c des segments droits tout en préservant à l'intérieur du segment courbe 12a une épaisseur de diélectrique 11 suffisante pour isoler électriquement cette portion de piste 12a. Dans le deuxième cas, l'épaisseur de diélectrique est donc juste inférieure à la longueur du dépassement 12c du segment droit comme le montrent les figures 15b, 16b, 16c et 17. Comme on le verra plus loin, ces dépassements 12c joueront un rôle lors de la métallisation des vias.

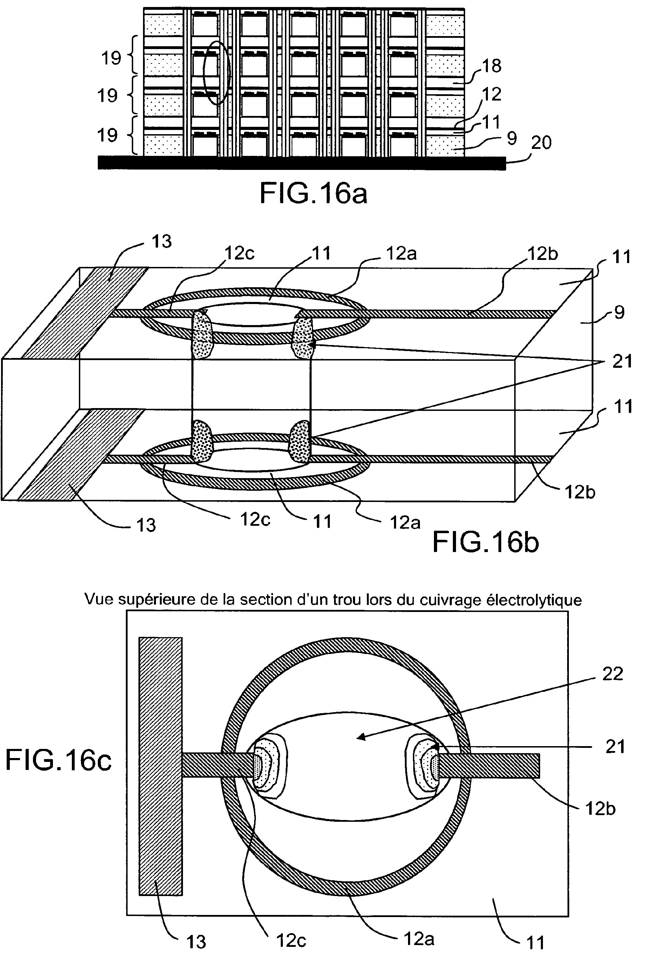

Les figures 16 montrent ces mêmes vias 15 perforés, à présent métallisés. Cette métallisation peut être obtenue de plusieurs façons. Selon un premier mode de réalisation, la métallisation est obtenue par dépôt d'une fine couche métallique (« seed layer ») accrochée à la paroi du via par voie chimique ou sous vide. Cette technique est de moins en moins fiable au fur et à mesure que le rapport R entre la longueur des vias 15 (proportionnelle au nombre de plaques empilées et à leur épaisseur) et la plus grande dimension de leur section augmente. Lorsque R>10, la métallisation n'est pas régulièrement répartie le long du via ; elle n'atteint pas le fond du via. Cela nécessite alors d'élargir les vias au détriment de leur nombre. De manière avantageuse, le remplissage des vias par un métal conducteur 21 est réalisé par électrolyse par exemple par cuivrage électrolytique, sans présence de seed layer métallique. Le métal conducteur 21 peut être du cuivre bien sûr mais aussi du nickel ou de l'or ou de l'argent ou de l'étain. Le courant est amené dans les vias 15 par les électrodes 13 d'interconnexion des pistes puis par les segments des pistes qui s'étendent jusqu'aux vias. Le via et les segments de pistes représentés figure 16c ont typiquement les dimensions suivantes : l'électrode 13 a environ 40 µm de large, les segments droits 12b environ 20 µm de large, les dépassements 12c environ 10 µm de large et 25 µm de long, le segment courbe 12a environ 5 µm de large, un plot de connexion 4 environ 60 µm x 60 µm, le diélectrique 11 à l'intérieur de l'emplacement 15a environ 15 µm d'épaisseur, le via environ 80 µm de long sur 40 µm de large. Sont représentés figures 17a à 17h différents exemples de formes de vias, de segments courbes et de segments droits avec dépassements : via oblong avec une piste en anneau avec 2 dépassements 12c (figure 17a), demi-anneau avec 2 dépassements 12c (figures 17b et 17d) ou 1 dépassement 12c (figure 17c), via triangulaire avec un demi-anneau avec 2 dépassements 12c (figure 17f), ou 1 dépassement 12c (figure 17e), via rectangulaire avec un demi-anneau avec 2 dépassements 12c (figure 17g). Lorsqu'il y a deux dépassements 12c de segments, cela double les chances de connexion verticale ; s'il n'y a qu'un dépassement 12c de segment, cela augmente le volume de passage du liquide électrolytique 22. Selon une variante montrée figure 17h, le via 15 est formé de façon à laisser un rétrécissement local pour limiter la croissance du cuivrage en X et Y au profit de la croissance en Z, c'est-à-dire selon la direction de l'empilement. Les figures 16 b, c et d illustrent la progression du cuivrage électrolytique au cours du temps : la métallisation croît à partir des sections 12c des segments. La durée de cette électrolyse est calculée pour que la connexion verticale d'une plaque 19 à l'autre soit réalisée. La connexion électrique peut ainsi être assurée pour des vias présentant une section de 40 µm à 80 µm et une longueur de 500 µm à 800 µm, soit un rapport R de 10 à 15.

La figure 18 montre l'empilement de KGRWs 19 interconnectés verticalement sur lequel est déposée une couche polymère de protection 23 des pistes 12.

La figure 19 montre la découpe de l'empilement de KGRWs en vue d'obtenir les modules 3D. Elle est réalisée le long des chemins de découpe 14, d'une manière analogue à celle d'une découpe sur simple plaque. La largeur de la découpe est supérieure à la largeur de l'électrode 13 d'interconnexion des pistes pour éviter le court-circuit entre les pistes des futurs modules 3D. Dans cette technologie, les vias 15 métallisés disposés le long des rangées 1 à n sont distincts des chemins de découpe 14.

La figure 20 montre un module 3D final, débarrassé du film de montage 20.

## Revendications

1. Procédé d'interconnexion verticale de n modules électroniques 3D (100), n étant un entier supérieur à 1, un module comportant un empilement de K tranches électroniques (19), une tranche i, i variant de 1 à K comprenant au moins un composant électronique (6), les K tranches étant reliées électriquement entre elles par des conducteurs situés selon la direction de l'empilement, et comprend une première étape consistant pour chaque tranche i, en :
A1) une étape de fabrication d'un lot de n tranches (19) sur une même plaque, une plaque comportant au moins n motifs géométriques délimités par des chemins de découpe (14), chaque motif étant muni d'au moins un composant électronique (6) entouré de résine isolante (9) et connecté à des plots (4) de connexion électrique, les plots étant reliés à des pistes (12) de connexion électrique déposées sur une couche diélectrique (11) qui recouvre le composant électronique (6) et la résine (9) mais qui ne recouvre pas complètement les plots (4), chaque piste (12) s'étendant jusqu'à une électrode (13) interconnectant les pistes entre elles, et située sur un chemin de découpe délimitant le motif, chaque piste comprenant un segment courbe (12a) disposé entre 2 segments droits (12b), le segment courbe délimitant une zone (15a) qui entoure un emplacement destiné à former un via, cette zone étant disposée entre le plot de connexion (4) et l'électrode d'interconnexion des pistes (13),
A2) répéter K fois l'étape A1 pour obtenir K plaques,
une deuxième étape consistant à :
B) empiler et assembler les K plaques obtenues à l'issue de la première étape, de manière à superposer lesdites zones (15a), sensiblement les unes sur les autres,
C) percer des vias (15) dans la résine (9) selon la direction de l'empilement et sur toute l'épaisseur de celui-ci à l'aplomb desdits emplacements destinés à former des vias, la section des vias étant telle que pour chaque tranche (19), les segments droits (12b) affleurent sur les vias (15) mais pas les segments courbes (12a),
D) métalliser la paroi des vias (15) par croissance électrolytique,
E) découper l'empilement selon les chemins de découpe (14), la largeur de la découpe étant supérieure à celle de l'électrode (13), en vue d'obtenir les n modules électroniques 3D (100).

2. Procédé selon la revendication précédente, **caractérisé en ce que** le métal des vias est du cuivre ou du nickel ou de l'or ou de l'argent ou de l'étain.

3. Procédé selon l'une quelconque des revendications précédentes, **caractérisé en ce qu'**au moins un des segments droits présente un dépassement (12c) à l'intérieur de ladite zone (15a).

4. Procédé selon l'une quelconque des revendications précédentes, **caractérisé en ce que** le segment courbe (12a) est un arc de cercle ou un cercle ou un arc d'ellipse ou une ellipse, ou un demi-triangle ou un triangle ou un demi-rectangle ou un rectangle.

5. Procédé selon l'une quelconque des revendications précédentes, **caractérisé en ce que** le composant électronique est un composant actif ou passif ou un MEMS.

6. Procédé selon l'une quelconque des revendications précédentes, **caractérisé en ce qu'**au moins un composant passif est situé dans la plaque ou sur la plaque.

7. Procédé selon l'une des revendications précédentes, **caractérisé en ce que** les vias sont formés par gravure sèche par laser ou plasma.

8. Procédé selon l'une quelconque des revendications 1 à 6, **caractérisé en ce que** les vias sont formés par gravure liquide.

## Claims

1. A process for the vertical interconnection of n 3D electronic modules (100), n being an integer greater than 1, a module including a stack of K electronic wafers (19), a wafer i, i varying from 1 to K, including at least one electronic component (6), the K wafers being electrically connected together by conductors located in the direction of the stack, and comprising a first step which, for each wafer i, consists in:
A1) a step for manufacturing a batch of n wafers (19) on the same plate, a plate comprising at least n geometrical patterns delimited by cutting lines (14), each pattern being provided with at least one electronic component (6) encompassed by insulating resin (9) and connected to electrical connection pads (4), the pads being connected to electrical connection tracks (12) arranged on a dielectric layer (11) which covers the electronic component (6) and the resin (9) but which does not entirely cover the pads (4), each track (12) extending to an electrode (13) which interconnects the tracks and is located on a cutting line delimiting the pattern, each track including a curved segment (12a) disposed between 2 straight segments (12b), the curved segment delimiting a zone (15a) which encompasses a location designed to form a via, this zone being disposed between the connection pad (4) and the track interconnection electrode (13),
A2) repeating step A1 K times to obtain K plates,
a second step which consists in:
B) stacking and assembling the K plates obtained on completion of the first step, so that said zones (15a) are essentially superposed on one another,
C) drilling vias (15) in the resin (9) in the direction of the stack and over its entire thickness perpendicular to said locations designed to form vias, the section of the vias being such that for each wafer (19) the straight segments (12b) are flush with the vias (15) but not with the curved segments (12a),
D) metallising the wall of the vias (15) by electrolytic growth,
E) cutting the stack along the cutting lines (14), the width of the cut being greater than the width of the electrode (13), so as to obtain the n 3D electronic modules (100).

2. The process according to the previous claim, **characterised in that** the metal used for the vias is either copper, nickel, gold, silver or tin.

3. The process according to any one of the previous claims, **characterised in that** at least one of the straight segments has a protrusion (12c) inside said zone (15a).

4. The process according to any one of the previous claims, **characterised in that** the curved segment (12a) is a circular arc or a circle or an elliptical arc or an ellipse, or a semi-triangle or a triangle or a semi-rectangle or a rectangle.

5. The process according to any one of the previous claims, **characterised in that** the electronic component is an active or passive component or an MEMS.

6. The process according to any one of the previous claims, **characterised in that** at least one passive component is located in the plate or on the plate.

7. The process according to any one of the previous claims, **characterised in that** the vias are formed by dry laser etching or dry plasma etching.

8. The process according to claims 1 to 6, **characterised in that** the vias are formed by wet etching.

## Patentansprüche

1. Verfahren zur vertikalen Verbindung von n 3D-Elektronikmodulen (100), wobei n eine ganze Zahl größer als 1 ist, wobei ein Modul einen Stapel von K Elektronikwafern (19) enthält, einem Wafer i, wobei i von 1 bis K variiert, umfassend wenigstens eine elektronische Komponente (6), wobei die K Wafer durch Leiter elektrisch miteinander verbunden sind, die sich in der Richtung des Stapels befinden, und das einen ersten Schritt beinhaltet, der für jeden Wafer i besteht aus:
A1) einem Schritt zur Herstellung eines Loses von n Wafern (19) auf derselben Platte, wobei eine Platte wenigstens n durch Schnittlinien (14) begrenzte geometrische Muster aufweist, wobei jedes Muster mit wenigstens einer elektronischen Komponente (6) versehen ist, die von Isolierharz (9) umgeben und mit elektrischen Kontaktstellen (4) verbunden ist, wobei die Kontaktstellen mit elektrischen Leiterbahnen (12) verbunden sind, die auf einer dielektrischen Schicht (11) liegen, die die elektronische Komponente (6) und den Harz (9) bedeckt, die Kontaktinseln (4) aber nicht vollständig bedeckt, wobei jede Bahn (12) bis zu einer Elektrode (13) verläuft, die die Bahnen miteinander verbindet und sich auf einer das Muster begrenzenden Schnittlinie befindet, wobei jede Bahn ein gekrümmtes Segment (12a) aufweist, das zwischen 2 geraden Segmenten (12b) liegt, wobei das gekrümmte Segment eine Zone (15a) begrenzt, die einen Ort umgibt, an dem eine Durchkontaktierung gebildet werden soll, wobei diese Zone zwischen der Anschlussstelle (4) und der Bahnverbindungselektrode (13) angeordnet ist,
A2) Wiederholen von Schritt A1 K mal, um K Platten zu erhalten,
einen zweiten Schritt, der besteht aus:
B) Stapeln und Zusammenfügen der nach dem ersten Schritt erhaltenen K Platten, so dass die Zonen (15a) im Wesentlichen übereinander liegen,
C) Bohren von Durchkontaktierungen (15) in dem Harz (9) in Richtung des Stapels und über seine gesamte Dicke lotrecht zu den Orten, an denen Durchkontaktierungen gebildet werden sollen, wobei der Querschnitt der Durchkontaktierungen so ist, dass für jeden Wafer (19) die geraden Segmente (12b) mit den Durchkontaktierungen (15), nicht aber mit den gekrümmten Segmenten (12a) bündig sind,
D) Metallisieren der Wand der Durchkontaktierungen (15) durch elektrolytisches Wachstum,
E) Schneiden des Stapels entlang der Schnittlinien (14), wobei die Breite des Schnitts größer ist als die Breite der Elektrode (13), um die n 3D-Elektronikmodule (100) zu erhalten.

2. Verfahren nach dem vorherigen Anspruch, **dadurch gekennzeichnet, dass** das für die Durchkontaktierungen verwendete Metall Kupfer, Nickel, Gold, Silber oder Zinn ist.

3. Verfahren nach einem der vorherigen Ansprüche, **dadurch gekennzeichnet, dass** wenigstens eines der geraden Segmente einen Vorsprung (12c) ins Innere der Zone (15a) hat.

4. Verfahren nach einem der vorherigen Ansprüche, **dadurch gekennzeichnet, dass** das gekrümmte Segment (12a) ein Kreisbogen oder ein Kreis oder ein elliptischer Bogen oder eine Ellipse oder ein Teildreieck oder ein Dreieck oder ein Teilrechteck oder ein Rechteck ist.

5. Verfahren nach einem der vorherigen Ansprüche, **dadurch gekennzeichnet, dass** die elektronische Komponente eine aktive oder passive Komponente oder ein MEMS ist.

6. Verfahren nach einem der vorherigen Ansprüche, **dadurch gekennzeichnet, dass** sich wenigstens eine passive Komponente in der Platte oder auf der Platte befindet.

7. Verfahren nach einem der vorherigen Ansprüche, **dadurch gekennzeichnet, dass** die Durchkontaktierungen durch Trockenlaserätzen oder Trockenplasmaätzen gebildet werden.

8. Verfahren nach einem der Ansprüche 1 bis 6, **dadurch gekennzeichnet, dass** die Durchkontaktierungen durch Flüssigätzen gebildet werden.
